# EUROPEAN PATENT APPLICATION

(11) **EP 0 936 506 A2**
(43) Date of publication of application: **18.08.1999**
(21) Application number: 99300970.3
(22) Date of filing: 10.02.1999
(51) Int. Cl.: G03F 7/36, G03F 7/42

(54) **Dry process for the development and stripping of photoresists**

(30) Priority: 11.02.1998 US 21175
(71) Applicant: E.I. DU PONT DE NEMOURS AND COMPANY, Wilmington Delaware 19898 (US)
(72) Inventor: Felten, John James, Chapel Hill, North Carolina 27516 (US); Hawkins, Raymond Eugene (Jr.), Raleigh, North Carolina 27613 (US); Lott, John Walter, Durham, North Carolina 27707 (US); Padlewski, Stephan, Raleigh, North Carolina 27613 (US); Wessel, Richard Alan, Raleigh, North Carolina 27613 (US)
(74) Representative: Towler, Philip Dean

(57) **Abstract**

A dry process is disclosed for development and stripping of photoresists in printed circuit board applications employing a photoresist developed by blasting media.

## Description

This invention relates to a dry process for the development and stripping of photoresists in printed circuit board applications. More particularly, it is directed to such a process in which the photoresist is developed by blasting media.

In the manufacture of printed circuit boards, a temporary photosensitive polymeric resist, known as a photoresist, is applied to a printed circuit substrate. The photoresist is imagewise exposed to actinic radiation, resulting in a differentiation in the solubility properties of the exposed and nonexposed areas. The exposed photoresist is then developed by treatment with liquid developer to remove the more soluble areas, resulting in a mask on the substrate. The uncovered surface areas of the substrate which are not protected by the remaining resist image, are then modified by either removal with an etchant or by treatment with plating chemicals to deposit additional material. After the surface areas of the substrate are modified, the photoresist image is typically stripped, that is, removed, before subsequent steps are performed to produce a printed circuit. Stripping of the photoresist image is usually accomplished by treatment with liquids and vapors, which are typically organic solvents, aqueous alkaline solutions, or combinations thereof. As circuit density becomes greater, and circuit features become smaller, resist removal becomes more difficult requiring longer chemical exposure time and additional controlled conditions to satisfactorily produce fine line circuitry. Since the liquids and vapors used to removed the resist frequently are vigorous organic solvents and/or caustic solutions, added safety measures are required to carry out this operation. Safe environmental disposal of spent waste liquids add further concern.

A need exists in the printed circuit industry to simplify and shorten the resist development and stripping processes without damaging the delicate printed circuit lines or the underlying substrate material. The demand extends to a process which yields waste of very low environmental impact, one without caustic liquids intermingled with spent photoresist; waste which can be disposed of in an ordinary landfill; waste which can be recycled or reused.

### SUMMARY OF THE INVENTION

The present invention provides a method for developing and stripping photoresists in printed circuit applications which is a dry process. It is also a process resulting in waste of very low environmental impact.

As used herein, by "photoresist" is meant a material which is sensitive to actinic radiation, such that exposure to actinic radiation causes a change in the physical properties. The photoresist can be provided in either liquid or film form. By "photohardenable" is meant a composition which becomes less soluble to a give developer solution upon exposure to actinic radiation. This includes photopolymerizable compositions, photocrosslinkable compositions, and mixtures or variations.

In the process of the invention a photohardenable photoresist is developed and stripped by the projection of abrasive media particles onto the photoresist. The abrasive media particles remove the photoresist material in the exposed areas, resulting in areas where the surface of the printed circuit substrate is uncovered. After a second overall exposure step, the remaining photoresist is removed again by the projection of abrasive media particles onto the surface.

The dry process for the development and stripping of photoresists comprising the steps:
a) applying a photoresist to the surface of a printed circuit substrate;
b) imagewise exposing the photoresist to actinic radiation, resulting in exposed areas and unexposed areas;
c) projecting solid particles of abrasive media onto the surface of the exposed resist to selectively remove the exposed areas, resulting in areas of the printed circuit substrate which are uncovered;
d) treating the uncovered areas of the printed circuit substrate with material selected from etchant, plating chemicals, and combinations thereof;
e) overall exposing the exposed photoresist to actinic radiation; and
f) projecting particles of abrasive media onto the surface of the photoresist to remove the remaining photoresist;
wherein step b can be carried out either before or after step a.

In a preferred embodiment, the abrasive media particles are solid carbon dioxide.

### DESCRIPTION OF THE PREFERRED EMBODIMENTS

The first step in the process of the invention is to apply a photoresist to the surface of a printed circuit substrate.

The photoresists which can be used in the process of the invention are photohardenable materials and can be provided in either liquid or film form. In the unexposed state, the photoresist must be able to withstand the projection of abrasive media particles without itself being completely abraded away or chipped. In the exposed state, the photoresist must be completely removed by the abrasive media particles.

The photoresist can be a single layer or multilayer film. In multilayer applications, the layers can have the same or different compositions. All the layers must be removable by the projection of abrasive media particles after exposure to actinic radiation. At least the outer photoresist layer should be photohardenable. Some or all of the inner layer(s) can be non-photosensitive as long as they are removable by the projection of abrasive media particles. It is preferred that all of the layers be photohardenable. The term "photoresist", as used herein, shall indicate both single-layer and multilayer structures.

Photohardenable materials are well known in the art and commonly used as photoresists. Suitable materials have been described in many references, for example, "Photoresist -- Materials and Processes", by W. S. DeForest (McGraw-Hill, 1975), "Photoreactive Polymers -- The Science and Technology of Resists", by A. Reiser (John Wiley & Sons, 1989), and "Radiation Curing: Science and Technology", edited by S. P. Pappas (Plenum Press, 1992). Such materials generally comprise (a) a polymerizable or cross-linkable compound, (b) a photoinitiator system, and (c) a binder.

Suitable polymerizable or cross-linkable compounds include ethylenically unsaturated compounds which undergo free-radical initiated polymerization, including monomers and oligomers. Also suitable are self-crosslinkable polymers and polymers having reactive groups in combination with monomers and/or oligomers. The term "reactive compound" shall be used herein to refer to all types of polymerizable or cross-linkable compounds. Typical monomers are: unsaturated esters of alcohols, such as the acrylic and methacrylic acid esters of aliphatic alcohols, including polyols, having 1 to 12 carbon atoms; unsaturated amides; vinyl esters, such as divinyl succinate, divinyl phthalate and divinyl benzene-1,3-disulfonate; styrene and derivatives thereof; N-vinyl compounds, such as N-vinyl carbazole; acrylate, methacrylate and acryloxy derivatives of bisphenol A.

Suitable photoinitiator systems include free radical-generating compounds activatable by actinic radiation. Typical initiator systems include: the substituted or unsubstituted polynuclear quinones; vicinal ketaldonyl alcohols; acyloin ethers; alpha-hydrocarbon-substituted aromatic acyloins; photoreducible dyes and reducing agents; Michler's ketone, preferably substituted Michler's ketone or derivatives of Michler's ketone; benzophenone; 2,4,5-triphenyl-imidazolyl dimers with hydrogen donors; and mixtures.

Suitable binders include alkyl acrylate and methacrylate polymers and copolymers; poly(vinyl acetate) and its partially hydrolyzed derivatives; cellulose esters and ethers; styrene and substituted styrene polymers and copolymers; styrene/maleic anhydride copolymers.

Other components conventionally added to photopolymer compositions can be present to modify the physical properties of the film. Such components include: plasticizers, thermal stabilizers, optical brighteners, ultraviolet radiation absorbing material, adhesion modifiers, coating aids, and release agents.

A plasticizer may be present to modify adhesion, flexibility, hardness and other mechanical properties of the film in a conventional fashion. When a binder is present, a plasticizer would be selected which is compatible with the binder as well as the reactive compound. With acrylic binders, for example, plasticizers can include dibutyl phthalate and other esters of aromatic acids; esters of aliphatic polyacids; aromatic or aliphatic acid esters of glycols, polyoxyalkylene glycols, aliphatic polyols; alkyl and aryl phosphates; and chlorinated paraffins.

In the composition of the photoresist to be used in the process of the invention, the components must be chosen so as to balance the needed flexibility and resistance to blasting media particles of the unexposed material, with the removability of the exposed material by the blasting media particles. In general, it is desired that the exposed material be brittle to facilitate removal. In general, this brittleness can be achieved by using reactive compounds, especially monomers and oligomers, which have larger numbers of reactive groups, for example, monomers with multiple sites of unsaturation. It also can be increased by decreasing the spacing between the reactive groups in the reactive compound, thereby decreasing the molecular weight. Further, the brittleness can be increased by decreasing the amount of plasticizer present.

The photoresist typically has a dry thickness in the range of 2.5 to 125 microns. A preferred thickness is from 25 to 75 microns.

When provided as a film, the photoresist can also comprise a removable coversheet on one or both outer surfaces, to provide support for the photohardenable film and protection from physical damage or contamination. These can be sheets or films of synthetic organic resin, cellulose paper, fiberboard, and the like, or composites of two or more of these materials. Particularly suitable materials include polyethylene terephthalate, polyethylene, and polypropylene. The coversheet may also have a release coating, such as a silicone coating.

The photoresist can be applied to the substrate using any conventional technique. Liquid photoresists are generally applied by coating onto the substrate using conventional coating methods, and then dried to form a film. Most dry photoresist films have both a support and a coversheet. To apply the photoresist to the substrate, the support is removed and the photoresist is typically laminated onto the substrate.

Typical printed circuit substrates include fiberglass epoxy laminate, phenolic paper laminate, polyimide epoxy composites, fluoropolymer composites, bismaleimide triazine resin composites, ceramics, and flexible substrates such as polyamide, polyimide and polyester films. The substrate is frequently clad with a metal, such as copper.

It will be understood that the printed circuit substrate can be a dielectric substrate, a copper clad substrate, or a circuit assembly in a variety of different stages of formation. The printed circuit substrate can have multiple layers. The substrate can have holes or vias for electrical connection between layers that have been punched, drilled, etched, ablated, or otherwise formed. The substrate can have layers buried beneath the layer to be processed and can have vias and/or through holes connecting this layer to other layers on either side of the existing circuit assembly. Furthermore, the treated printed circuit substrates resulting from the process of the invention can be placed together with intervening layers of dielectric insulating adhesive and formed into a multilayer circuit connected by vias and through holes.

The second step in the process of the invention is to imagewise expose the photoresist to actinic radiation, resulting in exposed areas and unexposed areas of the resist. This step can be carried out either before or after the first step. When the photoresist is applied to the substrate as a liquid solution, the exposure step will be carried out second. When the photoresist is applied to the substrate as a film, the exposure step can be carried out either before or after applying the film to the substrate.

Any convenient source or sources of actinic radiation providing wavelengths in the region of the spectrum that overlap the absorption bands of the photoinitiator system can be used to activate the photohardening reaction(s). By "actinic radiation" is meant radiation which is active to produce the species necessary to initiate the photohardening reaction(s). The radiation can be natural or artificial, monochromatic or polychromatic, incoherent or coherent, and for high efficiency, should correspond closely in wavelength to the absorption of the initiator system. Conventional light sources include fluorescent lamps, mercury, metal additive and arc lamps. Coherent light sources are xenon, argon ion and ionized neon laser, as well as tunable dye laser and the frequency double neodymium:YAG laser, whose emissions fall within or overlap the visible absorption bands of the photoinitiator system. Although exposure is typically carried out through an image-bearing transparency, modulated scanning laser and cathode-ray tubes can also be used. The exposure time and intensity vary with the specific photopolymer and imaging systems used.

The third step in the process of the invention is to project abrasive media particles onto the surface of the photoresist to,selectively remove the exposed areas. This results in areas of the printed circuit substrate being uncovered.

If a coversheet is present on the outer surface of the photoresist, this can be removed prior to application of the abrasive media particles. However, if the coversheet is thin and easily removed by the blasting media, it may be left on.

The abrasive media is preferably solid particles of carbon dioxide. This material has the advantage that the projecting media add no waste to the process. The particles simply evaporate to form a harmless gas and have very low environmental impact.

Carbon dioxide particles for blasting can be prepared as described in U.S. Patent 4,631,250. Alternatively, solid carbon dioxide can be ground into particles and propelled using compressed air. In a preferred process, solid carbon dioxide is ground and screened into particles having a diameter of 10 mil (254 microns) or less and propelled with compressed air that has been heated to above 100°F (38°C); preferably 130 to 160°F (54 to 71°C).

The abrasive media particles can also be any material conventionally used for blasting. Such materials include aluminum oxide, steel shot or grit, garnet, sand, glass beads, silica, granite and solid polymeric beads. The size of the particles is limited only in that they must be able to remove the exposed areas of the photoresist mask in a pattern with the desired resolution. In general, particles with a diameter in the range of 50 to 200 microns are useful. Abrasive material is frequently sized by grit size, with higher grit numbers indicating small particles. Using this scale, particles of 80 to 280 grit are generally acceptable. To be effective, the particles generally have a Moh hardness of greater than 2.

The abrasive media particles can be propelled or projected in any conventional method. This can be done in a gaseous or liquid fluid, or it may be projected by some other mechanical means. Typically, pressurized air is used to accelerate and direct the media using a pneumatic sand blaster, or similar device. Although not preferred, the blasting media may also be accelerated as a water slurry or dispersion and projected as a stream onto the substrate surface or the media particles may be injected into a projected water stream. The media propelling means should produce a media flow equivalent to pneumatically propelled media flow of about 15 to 60 pounds per square inch (103.4 to 413.7 kPa)

The fourth step in the process of the invention is to treat the uncovered areas of the printed circuit substrate with etchant or with plating chemicals. This is a conventional step in the manufacture of printed circuit boards, and has been described in detail in, for example, "Printed Circuits Handbook" edited by C. F. Coombs (McGraw-Hill, 1979). Etchants are generally applied to remove areas of metal from the surface of the printed circuit substrate, and include mixtures of ammonium hydroxide and ammonium chloride, and mixtures of cupric chloride and hydrochloric acid with peroxide regeneration. Other etchants such as ferric chloride and strong acids and bases may also be used. Plating chemicals include solutions of plating catalysts and electroless and electrolytic metal plating solutions.

The fifth step in the process of the invention is to expose the remaining photoresist overall with actinic radiation. This results in the photohardening of the remaining photoresist. The source of actinic radiation can be selected from those discussed above, and can be the same or different than that used in step 2.

The sixth step in the process of the invention is to project particles of abrasive media onto the surface of the photoresist to remove it. The same abrasive media that was used in step 3 is usually used here, although different media can be used. The means of propelling the media particles and the flow pressure are generally the same as in step 3.

Using blasting for the development and stripping steps eliminates the need to use water and the associated need for water generation, capture and waste treatment. This greatly reduces the overall process cost. It has been shown that water and sewer costs of both process and rinse water can significantly add to the cost of a process. Furthermore, the waste in the development and stripping steps is dry waste. This is more conducive to recycling and reuse of chemicals.

An additional advantage of the process of the invention is that the photoresist is, in effect, positive-working. Many conventional photoresists are negative-working, that is, the areas that are not exposed to actinic radiation are removed in the development step. If there are any small particles of dust or other contaminants present in the exposure step, either on the phototool or between the exposure source and the phototool, there will be small areas of unexposed photoresist in the areas that are exposed. These small areas of unexposed material are washed out in the development step leading to pinholes in the developed photoresist. Thus the underlying substrate will be processed in areas where it was not intended for this to occur. In the positive-working system of the invention, the exposed areas of the photoresist are removed by the blasting material in the development step. Any dust or contaminant in the exposure step results in small areas of unexposed photoresist within the exposed areas. However, these areas are so tiny, that they are usually removed with the rest of the exposed photoresist in blasting development, and thus do not cause a defect.

### EXAMPLES

The following examples are illustrative of the invention, but not intended to be limiting.

### EXAMPLE 1

This example illustrates the use of blasting material to develop a photoresist.

A photoresist was prepared with the following composition:

| Component | Weight (g) |
|---|---|
| Elvacite® 2010 | 29.65 |
| o-Cl HABI | 4.61 |
| Ethyl Michler's ketone | 0.57 |
| Tris([p-diethylamino]-o-tolyl)methane | 0.57 |
| Trimethylolpropane triacrylate | 34.59 |
| Elvacite® 2010 is a copolymer of methyl methacrylate and ethyl acrylate available from ICI America (Wilmington, DE) | |
| o-Cl HABI is 2,2',5-tris-(o-chlorophenyl)-4-(3,4-dimethoxyphenyl)-4',5'-diphenylbiimidazole | |

70 grams of dibutyl acetate was mixed with the Elvacite® 2010 and heated to 130°C until dissolved. The solution was then cooled to 60°C and the remaining ingredients were added.

The above solution was screen printed onto a precleaned copper clad FR-4 printed circuit substrate to a dried thickness of 1.0 mil (25.4 microns). The photopolymer film was then imagewise exposed through a resolution target phototool at 100 mJ/cm².

The exposed photoresist was developed by sandblasting with fine silica having a particle size of 1 mil (25.4 microns) using compressed air at a pressure of 15 psi (103.4 kPa) and a nozzle distance of 5 inches (12.7 cm). This resulted in uncovering the copper in the areas of the photoresist that had been exposed to actinic radiation.

The substrate was then processed in a commercial acid etch of cupric chloride/hydrochloric acid to remove unprotected copper.

The resolution was 5 mils (127 microns).

### EXAMPLE 2

This example illustrates the use of blasting material to develop a photoresist.

A photoresist was prepared, applied to a substrate and imaged as described in Example 1. The exposed photoresist was developed using carbon dioxide particles propelled by compressed air. The particles had been ground to about 10 mil (254 microns) in diameter and the compressed air heated to 140-150°F (60-66°C). The air pressure was 30 to 60 psi (206.8 to 413.7 kPa).

The uncovered copper surface was etched as described in Example 1.

The resolution was 10-15 mils (254-381 microns).

### EXAMPLE 3

This example illustrates the use of blasting material to strip a developed photoresist.

A copper clad FR-4 printed circuit substrate was coated with Vacrel® 8415 photopolymer (E. I. du Pont de Nemours and Company, Wilmington, DE) to a dry thickness of 4 mils (102 microns). This was exposed and developed conventionally. The unexposed areas were washed out uncovering the copper below, and exposed photoresist was left on the substrate. The uncovered copper was then conventionally etched with a resolution of 2-3 mil lines and spaces (50-76 microns).

The developed photoresist, which had been exposed above, was then stripped using carbon dioxide particles propelled by compressed air. The particles were 0.125 inches (0.32 cm) in diameter and 0.5 inches (1.3 cm) long. The blasting pressure was varied between 40 to 125 psi (275.8 to 861.8 kPa). The photoresist was removed from the traces throughout this range of pressure without damaging the copper traces. At a pressure of 100 psi (689.5 kPa), a sample 18 x 15 inches (46 x 38 cm) could be stripped in 4 to 5 seconds.

### EXAMPLE 4

This example illustrates the use of blasting media to both develop and strip a photoresist.

An exposed photoresist on a printed circuit substrate is prepared as described in Example 1. The exposed photoresist is developed using carbon dioxide particles having a diameter of 0.5 to 1.0 mil (12.7 to 25.4 microns) using compressed air which has been dried and heated to 140°F (60°C), at a pressure of 50 psi (344.7 kPa). The exposed copper is then etched as described in Example 1.

The photoresist is given an overall exposure at 100 mJ/cm². The remaining photoresist is then stripped using carbon dioxide particles as described above for the development step. The resolution is 5 mils (127 microns).

## Claims

1. A dry process for the development and stripping of photoresists comprising the steps:
a) applying a photoresist to the surface of a printed circuit substrate;
b) imagewise exposing the photoresist to actinic radiation, resulting in exposed areas and unexposed areas;
c) projecting solid particles of abrasive media onto the surface of the exposed resist to selectively remove the exposed areas, resulting in areas of the printed circuit substrate which are uncovered;
d) treating the uncovered areas of the printed circuit substrate with material selected from etchant and plating chemicals;
e) overall exposing the exposed photoresist to actinic radiation; and
f) projecting particles of abrasive media onto the surface of the photoresist to remove the remaining photoresist;
wherein step b can be carried out either before or after step a.

2. The process of Claim 1 wherein the photoresist is applied as a liquid.

3. The process of Claim 1 wherein the photoresist is applied as a dry film.

4. The process of Claim 3 wherein step b is carried out before step a.

5. The process of Claims 1 to 4 wherein the abrasive media particles are selected from aluminum oxide, steel shot, garnet, sand, glass beads, silica, granite and solid polymeric beads.

6. The process of Claims 1 to 4 wherein the abrasive media particles are solid carbon dioxide.

7. The process of Claims 1 to 6 wherein step b is carried out by laser imaging.
